Europäisches Patentamt

European Patent Office

Office européen des brevets

(11) Veröffentlichungsnummer: **0 146 834**
**A2**

## (12) EUROPÄISCHE PATENTANMELDUNG

(21) Anmeldenummer: **84114722.6**

(22) Anmeldetag: **04.12.84**

(51) Int. Cl.⁴: **G 03 F 7/26**

(30) Priorität: **24.12.83 DE 3346979**

(43) Veröffentlichungstag der Anmeldung:
**03.07.85 Patentblatt 85/27**

(84) Benannte Vertragsstaaten:
**AT CH DE FR GB IT LI NL SE**

(71) Anmelder: **Merck Patent Gesellschaft mit beschränkter Haftung**
**Frankfurter Strasse 250**
**D-6100 Darmstadt(DE)**

(72) Erfinder: **Baron, Winfried**
**Fasanenstrasse 13**
**D-6101 Rossdorf 2(DE)**

(72) Erfinder: **Marquard, Kurt, Dr.**
**Am Bremelsberg 7**
**D-6107 Reinheim 1(DE)**

(72) Erfinder: **Merrem, Hans-Joachim, Dr.**
**Donnersbergstrasse 6**
**D-6104 Seeheim(DE)**

(72) Erfinder: **Sindlinger, Raimund**
**Steinackerstrasse 85**
**D-6105 Ober-Ramstadt(DE)**

(72) Erfinder: **Thiel, Klaus-Peter**
**Kirchbachstrasse 15**
**D-6101 Brensbach-Wersau(DE)**

(54) **Entwickler für Positiv-Fotoresists.**

(57) Ein Entwickler für Positiv-Fotoresists auf Basis einer gepufferten, nichtionogene Tenside enthaltenden wässerig-alkalischen Lösung, der in der Lösung 1 - 100 ppm der Tenside, vorzugsweise vom Typ der ethoxylierten Alkylphenole, enthält, ziegt hervorragende Eigenschaften hinsichtlich der im entwickelten Resistbild zu erzielenden Auflösung und Kantensteilheit sowie hinsichtlich seiner Entwicklungsaktivität, -kapazität und Stabilität.

EP 0 146 834 A2

Merck Patent Gesellschaft
mit beschränkter Haftung
D a r m s t a d t


Entwickler für Positiv-Fotoresists


Die Erfindung betrifft einen Entwickler für Positiv-Fotoresists mit verbesserten Eigenschaften hinsichtlich der im entwickelten Resistbild erzielbaren Auflösung und Kantensteilheit sowie hinsichtlich seiner Entwicklungsaktivität, -kapazität und Stabilität.

Fotoresistmaterialien sowohl vom Positiv- als auch vom Negativtyp werden bei der fotolithographischen Übertragung von Bildstrukturen in vielfältiger Weise eingesetzt.

In der Halbleitertechnologie und Mikroelektronik genießen Positivfotoresistmaterialien besondere Bedeutung, da sie bei der Übertragung von feinsten Bildstrukturen auf Leiter- und Halbleitersubstrate die heute immer noch bestmögliche Auflösung gewährleisten.

Zur Erzeugung von Positivresistbildern auf einem Substrat wird dieses mit dem Resistmaterial in Form eines Lackes beschichtet und dann ein Bildmuster durch Belichtung, beispielsweise durch eine Maske hindurch, auf die Fotolackschicht übertragen. In einem anschließenden Entwicklungsprozeß werden die belichteten Fotolackbereiche abgelöst, wodurch dann auf dem Substrat ein positives Reliefbild entsteht. An den freigelegten Substratbereichen kann nun eine weitere Strukturierung oder Modifizierung, beispielsweise durch eine Ätzung, durch Metallbeschichtung oder Dotierung erfolgen.

Die eingesetzten Positivfotoresistmaterialien sind üblicherweise lichtempfindliche Zusammensetzungen auf Basis von Phenol-Formaldehyd-Kondensaten vom Novolaktyp als Harzkomponenten und Verbindungen vom Typ der o-Diazochinone als lichtempfindliche Komponenten. Durch die Einwirkung von Licht, üblicherweise des UV-Bereichs, wird die Löslichkeit der belichteten Fotolackbereiche in einem wässerig-alkalischem Milieu drastisch erhöht. Solche Positivfotoresistmaterialien sind somit in wässerig-alkalischen Entwicklersystemen entwickelbar.

Die fortschreitende Miniaturisierung in der Halbleitertechnologie, insbesondere die VLSI-Technik (very large scale integration) zur Herstellung hoch- und höchstintegrierter elektronischer Bauelemente und Schaltungen erfordert ein Höchstmaß an Reproduktionsgenauigkeit bei diesen fotolithographischen Prozessen. Hierbei kommt dem Prozeßschritt der Entwicklung besondere Bedeutung zu.

Maßgeblich für die Qualität der zu erhaltenden Positivfotoresistreliefstrukturen in Bezug auf Auflösung, Kantenstruktur, verbleibender Schichtdicke und Oberflächenbeschaffenheit sind neben der Präzision der Belichtungsapparatur und den Eigenschaften des Fotolacks insbesondere die Einflüsse des Entwicklers während der Entwicklung.

Entwickler für Positivfotoresist nach dem Stand der Technik sind üblicherweise wässerige Lösungen von einen alkalischen pH-Wert bewirkenden Verbindungen.

Meist enthalten sie Alkalien, etwa Alkalihydroxide, oder Alkalisalze wie beispielsweise Alkalisilikate oder -phosphate. Die Entwickler können zur Stabilisierung des pH-Wertes der Lösung gepuffert sein und zur Verbesserung der Benetzungsfähigkeit die verschiedenartigsten Tenside enthalten

Die bekannten Entwickler haben jedoch den Nachteil, daß sie in nicht unbeträchtlichem Maße auch nichtbelichtete Bildbereiche der Resistschicht angreifen und einen deutlichen Schichtabtrag bewirken. Dies wird insbesondere auch in den Grenzbereichen zwischen den belichteten und nichtbelichteten Bildteilen deutlich, wo durch den Schichtabtrag des Entwicklers die im Idealfall anzustrebenden 90°-Kanten der verbleibenden Resistreliefstrukturen erheblich eingeschrägt und abgerundet werden. Dies führt zu einem nur mäßigen Kontrast, einer deutlichen Verringerung der durch die optischen Parameter vorgegebenen und möglichen Auflösung und einer ungenauen Bildwiedergabe für die nachfolgenden Prozesse wie Ätzen, Beschichten oder Dotieren des Substrats.

Weiterhin haben bekannte Entwickler nur eine begrenzte Stabilität und Entwicklungskapazität. Sie zeigen bei Lagerung und Benutzung Veränderungen in der Zusammensetzung, so daß die Reproduzierbarkeit der Entwicklungsergebnisse nicht über längere Dauer gewährleistet ist. Es ist deshalb üblich, die Entwicklungsprozesse mit aufwendigen apparativen Maßnahmen am zu entwickelnden Substrat fortlaufend zu überwachen und den Entwicklungsendpunkt festzustellen. Darüber hinaus werden Ausflockungen und Ablagerungen von Verunreinigungen und Abbauprodukten von Entwickler und Resistmaterial in der Entwicklerlösung und - besonders störend - auf dem Substrat beobachtet.

Es besteht daher Bedarf an verbesserten Positivfotoresistentwicklern für die Mikroelektronik, insbesondere die VLSI-Technik.

Der Erfindung lag somit die Aufgabe zugrunde, einen Entwickler für Positivfotoresists zu finden, der hinsichtlich der im Resistbild zu erzielenden Auflösung und Kantensteilheit sowie hinsichtlich Stabilität, Entwicklungsaktivität und -kapazität deutlich verbesserte Eigenschaften aufweist.

Überraschend wurde nun gefunden, daß ein Entwickler für Positivfotoresists auf Basis einer gepufferten, nichtionogene Tenside enthaltenden wässerig-alkalischen Lösung, der in der Lösung 1 - 100 ppm dieser Tenside enthält, ausgezeichnete Entwicklungseigenschaften sowie eine lange Stabilität besitzt.

Gegenstand der Erfindung sind somit Entwickler für Positivfotoresists auf Basis einer gepufferten, nichtionogene Tenside enthaltenden wässerig-alkalischen Lösung, der in der Lösung 1 - 100 ppm, vorzugsweise 10 - 60 ppm, insbesondere 30 - 50 ppm der Tenside enthält. Insbesondere ist Gegenstand der Erfindung ein solcher Entwickler, der Tenside vom Typ der ethoxylierten Alkylphenole enthält.

Weiterhin ist Gegenstand der Erfindung ein Verfahren zur Entwicklung von Positivfotoresistreliefstrukturen durch Behandlung einer belichteten Positivfotoresistbeschichtung mit einer Entwicklerlösung, wobei ein solcher Entwickler eingesetzt wird.

Zwar sind Entwickler für Positiv-Fotolack-Beschichtungen mit ähnlichen oder z.T. gleichen Inhaltsstoffen bekannt; sie weisen jedoch wesentlich höhere Tensidkonzentrationen auf und entsprechen in ihren Entwicklungseigenschaften nicht den heutigen Anforderungen an die VLSI-Technik.

So werden beispielsweise in der DE-OS 32 23 386 /USP 4,374,920 wässerig-alkalische Entwickler, die auch nichtionogene Tenside enthalten, beschrieben, die jedoch vornehmlich auf die Herstellung von Druckplatten zugeschnitten sind. Die angegebenen Konzentrationen von 0.1 - 10 Gew.% an Tensid (entsprechend 1000 bis 100000 ppm) haben hier die Aufgabe, das bei der Entwicklung freigelegte Druckplattenmaterial von einer Anätzung durch den Entwickler zu schützen. Diese Entwickler sind für die Herstellung hoch- und höchstintegrierter elektronischer Schaltungen und Bauelemente nicht geeignet.

In USP 3,586,504 werden Entwickler auf Basis wässeriger Natronlauge zur Herstellung von Metallmasken in der Mikroelektronik beschrieben, die nichtionogene Tenside vom speziellen Typ der Alkylphenoxypoly(hydroxyalkylenoxide) in einem Anteil von mindestens 0,05 Gew.% (entsprechend 500 ppm) enthalten. Auch diese Entwickler erfüllen nicht die heutigen Anforderungen im Hinblick auf die im Resistbild zu erzielende Auflösung und Kantensteilheit.

Als Tensidzusatz sind im Prinzip alle nichtionogenen Tenside, sofern sie alkalikompatibel sind, geeignet. Vorteilhaft sind nichtionogene Tenside vom Typ der ethoxylierten Alkylphenole. Kommerziell erhältlich sind Ethoxylierungsprodukte von Alkylphenolen mit 6 - 14 Kohlenstoffatomen in der Alkylkette und Ethoxylierungsgraden von 2 - 20. Besonders bevorzugt ist ein ethoxyliertes Nonylphenol mit einem mittleren Ethoxylierungsgrad von etwa 9. Die hervorragenden Entwicklungseigenschaften des erfindungsgemäßen Entwicklers werden dadurch erreicht, daß in ihm 1 - 100 ppm, vorzugsweise 10 - 60 ppm, insbesondere 30 - 50 ppm an solchen Tensiden enthalten sind.

Die Vorteile des erfindungsgemäßen Entwicklers gegenüber solchen nach dem Stand der Technik mit ähnlichen oder gleichen Inhaltstoffen zeigen sich in der Eigenschaft, Positivfotoresistreliefstrukturen mit einer bisher nicht erreichbaren Auflösung und Kantensteilheit zu entwickeln.

Es zeigt sich, daß der erfindungsgemäße Entwickler die unbelichteten Bildbereiche der Positivfotoresistschicht praktisch völlig unangegriffen läßt und erst ab einer Mindestbelichtungsenergie, die bei unterschiedlichen Fotolacken zwar variieren kann, meist aber um etwa 10 $mJ/cm^2$, bezogen auf 1 µm Schichtdicke, liegt, die belichteten Bildteile rasch und vollständig bis zum Substrat ablöst.

Ein Schichtabtrag durch den Entwickler in den unbelichteten Bereichen ist, sofern überhaupt erkennbar, minimal und beträgt weniger als 5%. Die Oberfläche der nach der Entwicklung verbleibenden Resistschicht ist glatt und eben und zeigt insbesondere nicht die sonst sehr häufig auftretenden und besonders gefürchteten, als "pinholes" bezeichneten Vertiefungen. Demgegenüber entfernt der erfindungsgemäße Entwickler die belichteten Fotoresistbildbereiche mit hoher Geschwindigkeit und restlos, so daß Reliefstrukturen mit bisher nicht erreichtem Kontrast und mit praktisch einer nur noch durch die optischen Parameter limitierten Auflösung erhalten werden. Die verbleibenden Reliefstrukturen zeigen nahezu ideale 90°-Kanten ohne Abrundungen und Einschrägungen.

Ein weiterer Vorteil des erfindungsgemäßen Entwicklers ist der weite zeitliche Entwicklungsspielraum, den dieser ermöglicht. Trotz der hohen Entwicklungsaktivität, die sich in einer besonders raschen Entfernung des belichteten Resistmaterials zeigt, werden bei einem längeren Verbleib des mit dem Resist beschichteten Substrates in der Entwicklerlösung die unbelichteten Bildbereiche nicht angegriffen; auch kommt es nicht zu Überentwicklungen. Durch diese Eigenschaft wird der Entwicklungsprozeß wesentlich unproblematischer; auf aufwendige Entwicklungsendpunktkontrollen im Prozeßablauf kann weitgehend oder vollständig verzichtet werden.

Es hat sich gezeigt, daß höhere als die angegebenen Tensidkonzentrationen sich ungünstig auswirken; vermutlich treten Aktivitätsverluste durch Passivierung auf. Es werden dann für eine vollständige Entwicklung längere Zeiten erforderlich, die wiederum einen verstärkten Schichtabtrag und Verluste an Kontrast und Auflösung bedingen. Weiterhin werden bei höheren Tensidkonzentrationen als sehr störend empfundene Ablagerungen von Tensid und von Anteilen beziehungsweise Abbauprodukten des Resistmaterials auf den freigelegten Substratbereichen festgestellt.

Über diese vorteilhaften Entwicklungseigenschaften hinaus zeigt der erfindungsgemäße Entwickler eine hervorragende Stabilität sowohl bei der Lagerung als auch bei Gebrauch. Bei sachgemäßer Herstellung, Lagerung und Verwendung bleibt die Zusammensetzung bemerkenswert konstant; Trübungen und Ausflockungen, die bei der Herstellung von mikroelektronischen Schaltungen und Bauteilen äußerst störend sind, werden nicht beobachtet. Durch diese ungewöhnliche Stabilität verfügt der Entwickler über eine höhere Entwicklungskapazität, so daß gleiche Volumeneinheiten der Entwicklerlösung bei einer wesentlich längeren Konstanz und Reproduzierbarkeit des Entwicklungsergebnisses besser ausgenutzt werden können.

Die Herstellung des erfindungsgemäßen Entwicklers erfolgt in an sich bekannter Weise. Hierzu werden die Einzelbestandteile in ihren mengenmäßigen Anteilen in Wasser, das vorteilhafterweise voll entsalzt und möglichst entgast sein sollte, gegebenenfalls unter Erwärmen gelöst. Insgesamt empfiehlt es sich, bei der Auswahl der Ausgangsstoffe auf höchste Reinheit und bei der Herstellung auf peinlichsten Ausschluß von Verunreinigungs- und Störungsmöglichkeiten zu achten. Entsprechende Reinheitskriterien sind in der Fachwelt unter der Bezeichnung "electronic grade" geläufig. Die übrigen Bestandteile des Entwicklers sind aus dem Stand der Technik bekannt. Die Entwickler enthalten im allgemeinen Alkaliverbindungen, die in wässeriger Lösung Hydroxylionen abzuspalten vermögen. Hierzu gehören z.B. Alkalisilikate, Alkalimetasilikat, Alkaliphosphate und Alkalihydroxid. Diese den alkalischen pH-Wert bewirkenden Substanzen sind im Entwickler in der Regel zu etwa 1 - 6 Gew.% enthalten, vorzugsweise etwa 2 - 5 Gew.%, bezogen auf die Gesamtmenge der Entwicklerlösung.

Bevorzugt ist ein Zusatz an Natrium- oder Kaliummetasilikat, vorzugsweise Natriummetasilikatpentahydrat. Als Puffersubstanzen kommen im Prinzip alle für solche Zwecke gängigen Alkalisalze von schwachen anorganischen Säuren beziehungsweise deren Gemische in Frage. Gut geeignet und deshalb bevorzugt sind Kalium- und Natriumphosphatpuffer, etwa auf Basis von primären, sekundären und/oder tertiären Natrium- und Kaliumphosphaten. Die günstigsten Entwicklungseigenschaften erzielt man, wenn der pH-Wert des Entwicklers im Bereich zwischen 12 und 14, vorzugsweise zwischen 12,5 und 13,5 liegt.

0146834

Der pH-Wert kann gegebenenfalls durch kontrollierte Zugabe von Alkalihydroxid eingestellt werden.

Mit dem erfindungsgemäßen Entwickler können prinzipiell alle Positivfotoresistmaterialien entwickelt werden, die im wesentlichen auf Gemischen von Harzkomponenten vom Novolaktyp und lichtempfindlichen Komponenten vom Typ der o-Diazochinone basieren. Insbesondere sind dies Gemische aus Kondensationsprodukten von Formaldehyd mit Phenolen oder phenolische Hydroxylgruppen enthaltenden Verbindungen und Naphthochinondiazidsulfonylderivaten. Solche Fotoresistzusammensetzungen sind vielfältig bekannt und beispielsweise in den Patentschriften DE-PS 938 233 / USP 3,106,465, DE-PS 11 95 166 / USP 3,201,239 sowie den deutschen Patentanmeldungen P 32 20 816 und P 33 44 202 beschrieben.

Das Verfahren zur Entwicklung von Positivfotoresistreliefstrukturen unter Anwendung des erfindungsgemäßen Entwicklers erfolgt in an sich bekannter Weise. Zunächst wird das Substrat, beispielsweise ein Silicium-Wafer, mit einer Positivfotoresistzusammensetzung in der erwünschten Schichtdicke beschichtet. Nach Trocknen des Lackes und einem zur Verbesserung der Haftung üblichen Temperschritt wird das beschichtete Substrat in einer gängigen Belichtungsapparatur durch eine Maskenvorlage bildhaft belichtet. Danach erfolgt der eigentliche Entwicklungsvorgang, wobei das die belichtete Resistschicht tragende Substrat kurzzeitig, etwa durch Tauchen oder Besprühen, dem erfindungsgemäßen Entwickler ausgesetzt wird. Hierbei entsteht dann auf dem Substrat ein der Maske entsprechendes Reliefbild höchster Präzision.

- 11 -

Nachfolgende Prozeßschritte am so strukturierten Substrat können nach einer eventuellen weiteren Temperung des Resistbildes beispielsweise sein Ätzprozesse, wie etwa Naß- oder Trockenätzen (zum Beispiel Plasmaätzen), Dotieren des Substrates, etwa durch Naßdotieren, Gasphasendiffusion oder Ionenimplantation, Metallbeschichten, etwa durch elektrolytische Metallabscheidung oder durch Bedampfungsprozesse.

Beispiel 1

a) Zusammensetzung des Entwicklers:

| | |
|---|---|
| 92,655 Gew.% | Wasser |
| 5,130 Gew.% | $Na_2SiO_3 \cdot 5H_2O$ |
| 1,250 Gew.% | $NaHPO_4 \cdot 2H_2O$ |
| 0,850 Gew.% | $Na_3PO_4 \cdot 12H_2O$ |
| 0,110 Gew.% | NaOH |
| 0,005 Gew.% ($\triangleq$ 50 ppm) | eines ethoxylierten Nonylphenols mit mittleren Ethoxylierungsgrad 9 |

b) Anwendung:

Ein handelsüblicher Positiv-Fotoresist-Lack auf Basis eines 5-Oxo-6-diazo-5,6-dihydronaphthalinsulfonsäureesters und eines Kresol-Formaldehyd-Novolakharzes wird durch Aufschleudern auf an der Oberfläche thermisch oxidierter Silizium-Wafer aufgetragen. Die Schichtdicke nach einem 30-minütigem Vortrocknen bei 90° beträgt 1,2 µm. Anschließend werden die Wafer im Kontaktbelichtungsverfahren durch eine Maske mit Strichmuster mit einer 200 W Hg-Lampe und einer Intensität von 6,5 mW/cm$^2$ bei 365 nm in unterschiedlichen Zeiten belichtet.

Danach werden die Wafer 60 Sekunden lang in dem Entwickler nach a) bei 22°C entwickelt. Nach der Entwicklung werden die erhaltenen Reliefstrukturen begutachtet und die verbleibende Restschichtdicke vermessen.

Folgende Restschichtdicken wurden in Abhängigkeit von der Belichtungszeit gefunden:

| Belichtungszeit | Restschichtdicke |
|---|---|
| 0 Sekunden (unbelichteter Bereich) | 1,15 μm |
| 0,5 Sekunden | 1,15 μm |
| 1,0 " | 1,15 μm |
| 1,5 " | 1,15 μm |
| 2,0 " | 0 μm |
| 2,5 " | 0 μm |

Eine rasterelektronenmikroskopische Auswertung der Strukturen im Fotolack zeigt, daß Muster mit einer Strukturbreite von 1 μm und darunter ab einer Belichtungszeit von 2 Sekunden sauber entwickelt und hoch aufgelöst sind, während bei Belichtungszeiten unter 2 Sekunden bzw. in den unbelichteten Bereichen ein Schichtabtrag von weniger als 5 % festzustellen ist. Die Reliefbilder zeigen glatte, ebene Oberflächen ohne Vertiefungen mit scharfen, steilen Kanten ohne Abrundungen oder Einschrägungen. Weder auf dem Resistbild noch auf dem freigelegten Substrat sind Ablagerungen von Verunreinigungen zu erkennen.

Beispiel 2

a) Zusammensetzung des Entwicklers:

| 96,365 Gew.% | Wasser |
|---|---|
| 2,210 Gew.% | $Na_2SiO_3 \cdot 5H_2O$ |
| 0,880 Gew.% | $Na_2HPO_4 \cdot 2H_2O$ |
| 0,440 Gew.% | $Na_3PO_4 \cdot 12H_2O$ |
| 0,100 Gew.% | NaOH |
| 0,005 Gew.%($\hat{=}$50 ppm) | Tensid wie in Beispiel 1a. |

b) Anwendung:

Die Anwendung analog zu Beispiel 1b liefert gleichermaßen gute Ergebnisse.

Beispiel 3

a) Zusammensetzung des Entwicklers:

| 96,460 Gew.% | Wasser |
|---|---|
| 2,210 Gew.% | $Na_2SiO_3 \cdot 5H_2O$ |
| 0,884 Gew.% | $Na_3PO_4 \cdot 12H_2O$ |
| 0,442 Gew.% | $Na_2HPO_4 \cdot 2H_2O$ |
| 0,004 Gew.%($\hat{=}$40 ppm) | Tensid nach Beispiel 1a. |

b) Anwendung

Die Anwendung analog zu Beispiel 1b liefert gleichermaßen gute Ergebnisse.

Vergleichsbeispiel A

a) Zusammensetzung des Entwicklers:

Wie in Beispiel 1a, jedoch mit 0,1 Gew.% ($\hat{=}$ 1000 ppm) des Tensides.

- 14 -                                    0146834

b) Anwendung:

Bei einer Entwicklung analog zu Beispiel 1b
sind selbst bei Belichtungszeiten von 10 Sekunden
keine vollständig entwickelten Reliefstrukturen
erhältlich.

Vergleichsbeispiel B

a) Zusammensetzung des Entwicklers:

Wie in Beispiel 1a, jedoch ohne Tensid.

b) Anwendung:

Bei einer Anwendung analog zu Beispiel 1b wird folgende Abhängigkeit der verbleibenden Restschichtdicke von
der Belichtungszeit gefunden:

| Belichtungszeit | Restschichtdicke |
|---|---|
| 0 Sekunden (unbelichteter Bereich) | 0,90 μm |
| 0,5 Sekunden | 0,75 μm |
| 1,0 " | 0,25 μm |
| 1,5 " | 0 μm |
| 2,0 " | 0 μm |
| 2,5 " | 0 μm |

Bei Belichtungszeiten unter 2 Sekunden und im unbelichteten Bereich ist ein erheblicher Schichtabtrag
festzustellen.

Die Reliefbilder zeigen ungleichmäßige Oberflächen
und stark abgerundete bzw. eingeschrägte Übergänge
in den Grenzbereichen zwischen Resist und freigelegtem Substrat.

Merck Patent Gesellschaft
mit beschränkter Haftung
D a r m s t a d t

Patentansprüche:

1. Entwickler für Positiv-Fotoresists auf Basis einer gepufferten, nichtionogene Tenside enthaltenden wässerig-alkalischen Lösung, dadurch gekennzeichnet, daß die Lösung 1 - 100 ppm der Tenside enthält.

2. Entwickler nach Anspruch 1, dadurch gekennzeichnet, daß er 10 - 60 ppm, vorzugsweise 30 - 50 ppm an Tensiden enthält.

3. Entwickler nach den Ansprüchen 1 und 2, dadurch gekennzeichnet, daß er als nichtionogene Tenside ethoxylierte Alkylphenole enthält.

4. Verfahren zur Entwicklung von Positiv-Fotoresist-Reliefstrukturen durch Behandlung einer belichteten Positiv-Fotoresist-Beschichtung mit einer Entwicklerlösung, dadurch gekennzeichnet, daß ein Entwickler nach den Ansprüchen 1 bis 3 eingesetzt wird.